# EUROPÄISCHE PATENTANMELDUNG

(11) **EP 4 703 741 A1**
(43) Veröffentlichungstag der Anmeldung: **04.03.2026**
(21) Anmeldenummer: 24197735.4
(22) Anmeldetag: 30.08.2024
(51) Int. Cl.: G01R 31/08

(54) **VERFAHREN UND VORRICHTUNG ZUM ERMITTELN EINES FEHLERORTES IN EINEM LEITER EINES ELEKTRISCHEN ENERGIEVERSORGUNGSNETZES**

(71) Anmelder: Siemens Aktiengesellschaft, 80333 München (DE)
(72) Erfinder: Huynh, Thanh Phong, 13629 Berlin (DE); Matussek, Robert, 10365 Berlin (DE)
(74) Vertreter: Siemens Patent Attorneys

(57) **Zusammenfassung**

Die Erfindung betrifft ein erfahren zum Ermitteln eines Fehlerortes in einem Leiter (2) eines elektrischen Energieversorgungsnetzes, bei dem an einer Messtelle (10a) am Anfang 4 und an einer Messstelle (10z) am Ende 5 des Leiters (2) Messensoren (12) angeordnet sind, die jeweils eine Messgröße erfassen, die den Zustand des Leiters (2) charakterisiert, wobei die Messsensoren (12) ausgangseitig Messignale bereitstellen und mit einem intelligenten elektronisches Gerät, IED, (14) verbunden sind, das aus den Messsignalen digitale Messwerte erzeugt. Damit ein Fehler innerhalb des Leiters besser erkannt und gleichzeitig der Fehlerort zuverlässiger eingegrenzt werden kann, wird vorgeschlagen, dass weitere Messsensoren (12) vorgesehen sind, die jeweils an weiteren Messtellen (10b, 10c) des Leiters (2) angeordnet sind und eine Messgröße an der zugeordneten Messtelle (, 10c) erfassen, die den Zustand eines zugeordneten Leiterabschnitts des Leiters (2) charakterisiert, wobei die Leiterabschnitte aufeinander folgend und hintereinander angeordnet sind und wobei die weiteren Messensoren (12) ebenfalls mit einem IED (14) verbunden sind und jedes IED (14) die aus dem jeweiligen Messsignal erzeugten Messwerte an eine Leitstellenanordnung (16) überträgt, die mit Hilfe eines Algorithmus die Messwerte auf das Vorliegen einer Fehlerbedinung hin untersucht und bei Vorliegen einer Fehlerbedingung ein Fehlersingal erzeugt.

## Beschreibung

Die Erfindung betrifft ein Verfahren zum Ermitteln eines Fehlerortes in einem Leiter eines elektrischen Energieversorgungsnetzes, bei dem an einer Messtelle am Anfang und einer Messstelle am Ende der Leitung Messsensoren angeordnet sind, die jeweils eine Messgröße erfassen, die den Zustand des Leiters charakterisiert, wobei die Messsensoren ausgangseitig Messignale bereitstellen und mit einem intelligenten elektronisches Gerät (IED) verbunden sind, das aus den Messsignalen digitale Messwerte erzeugt.

Die Erfindung betrifft weiterhin eine Vorrichung zur Überwachung eines Leiter eines elektrischen Energieversorgungsnetzes mit an einer Messtelle am Anfang und an einer Messtelle am Ende des Leiters angeordneten Messensoren, die jeweils eine Messgröße erfassen, die den Zustand des Leiters charakterisiert, wobei die Messsensoren ausgangseitig Messignale bereitstellen und mit einem intelligenten elektronisches Gerät (IED) verbunden sind, das aus den Messsignalen digitale Messwerte erzeugt.

Der sichere Betrieb elektrischer Energieversorgungsnetze erfordert die schnelle und zuverlässige Erkennung und Abschaltung etwaiger Fehler, wie z.B. Kurzschlüsse oder Erdschlüsse. Fehlerursachen, die eine Abschaltung bewirken, können beispielsweise Blitzeinschläge, gerissene oder anderweitig schadhafte Leitungen, fehlerhafte Isolierungen bei Kabelleitungen oder die ungewollte Berührung von Freileitungen mit Tier- oder Pflanzenteilen sein. Zur Verkürzung von fehlerbedingten Ausfallzeiten müssen solche Fehler möglichst genau lokalisiert werden, um eine Behebung der Fehlerursache und etwaiger durch den Fehler herbeigeführter Folgeschäden durch ein Wartungsteam zu ermöglichen.

Im einfachsten, aber auch aufwendigsten, Fall findet eine Fehlerortung durch Inaugenscheinnahme statt. Dabei fährt ein Wartungsteam die fehlerhafte Leitung ab und untersucht sie auf sichtbare Fehlerstellen. In diesem Zusammenhang ist der Einsatz von Drohnen bekannt, die mit Kamaras ausgerüstet sind und die fehlerhafte Leitung überfliegen. Dabei werden ihre Bilddaten an eine Zentralstelle übertragen. Diese Vorgehensweisen sind jedoch zeitintensiv und fehleranfällig.

Daher ist man weitgehend dazu übergegangen, den Fehlerort, an dem sich der Fehler auf der Leitung befindet, mittels einer Analyse von während des Fehlereintritts erfassten Messgrößen, beispielsweise Strömen und Spannungen, einzugrenzen. Hierfür sind mittlerweile mehrere unterschiedliche Verfahren bekannt, deren Genauigkeit sich signifikant auf den Wartungsaufwand des Energieversorgungsnetzes auswirkt. Daher wird großer Wert darauf gelegt, die Genauigkeit der Fehlerortung zu verbessern, um die Wartung zu erleichtern und insbesondere fehlerbedingte Ausfallzeiten des Energieversorgungsnetzes zu verkürzen.

Das eingangs genannte Verfahren und die eingangs genannte Vorrichtung sind dem Fachmann bereits bekannt. So ist es üblich, dass eine Messung zur Überwachung eines Leiters eines elektrischen Energieversorgungsnetzes an einer Messstelle am Anfang und an einer Messstelle am Ende des besagten Leiters durchzufühen. Der Abstand dieser Messstellen kann Entfernungen von mehreren hundert Kilometern betragen. Gibt es in mittleren Bereichen des besagten Leiters mehrere Abweichungen einer Messgröße wie Strom, Spannung oder Impedanz von einem vorgegebenen Nominalwert, können diese auf Grund der Anordnung der Messstellen am Anfang und am Ende des Leiters nur schlecht detektiert werden. Dadurch ist die selektive Fehlerbehebung schwierig. Liegen die Störungen mit Messgrößen, die Schwellenwerte über- und unterschreiten können, in aufeinander folgenden Leiterabschnitten können diese sich auch teilweise gegenseitig kompensieren. Dies kann auf Grund der akkumulierten Erfassung der Messgrößen an den Leiterenden ebenfalls unbemerkt bleiben.

Aufgabe der Erfindungs ist es daher, ein Verfahren und eine Vorrichtung der eingangs genannten Art zu schaffen, mit denen Fehler innerhalb des Leiters besser erkannt und gleichzeitig der Fehlerort zuverlässiger eingegrenzt werden kann.

Die Erfindung löst diese Aufgabe ausgehend von dem eingangs genannten Verfahren dadurch, dass weitere Messsensoren vorgesehen sind, die an weiteren Messtellen des Leiters angeordnet sind und eine Messgröße an der zugeordneten Messtelle erfassen, die den Zustand eines zugeordneten Leiterabschnitts charakterisiert, wobei die Leiterabschnitte aufeinander folgend und hintereinander angeordnet sind und wobei die weiteren Messensoren ebenfalls mit einem IED verbunden sind und jedes IED die aus dem jeweiligen Messsignal erzeugten Messwerte an eine Leitstellenanordnung überträgt, die mit Hilfe eines Algorithmus die Messwerte auf das Vorliegen einer Fehlerbedinung hin untersucht und bei Vorliegen einer Fehlerbedingung ein Fehlersingal erzeugt.

Die Erfindung löst diese Aufgabe ausgehend von der eingangs genannten Vorrichtung dadurch, dass weitere Messsensoren vorgesehen sind, die an weiteren Messtellen des Leiters angeordnet sind und eine Messgröße an der zugeordneten Messtelle erfassen, die den Zustand eines zugeordneten Leiterabschnitts charakterisiert, wobei die Leiterabschnitte aufeinander folgend und hintereinander angeordnet sind und wobei die weiteren Messensoren ebenfalls mit einem IED verbunden sind und jedes IED dazu eingerichtet ist, die aus dem jeweiligen Messsignal erzeugten Messwerte an eine Leitstellenanordnung zu übertragen.

Im Rahmen der Erfindung wird das Ziel, Fehlerzustände besser zu erkennen und gleichzeitig auf einfache Art und Weise eingrenzen zu können, durch eine erhöhte Anzahl von Messstellen erreicht, die Leiterabschnitte überwachen. Die Leiterabschnitte folgen räumlich aufeinander. Dabei wird im Rahmen der Erfindung von einem unverzweigten Leiter ausgegangen, der einen Teil eines elektrischen Energieversogungsnetzes ausbildet.

Der Leiter dient im Rahmen der Erfindung bevorzugt zum Übertragen von Energie über mehrere Kilometer. In der Regel weist dieser Leiter mehrere Phasenleiter, bevorzugt drei, Phasenleiter auf. Dabei liegt der Leiter auf einem Hochspannungspotential von über 1 kV, bevorzugt über 52 kV.

Grundsätzlich können beliebige Messsensoren im Rahmen der Erfindung eingesetzt werden. Insbondere können Strom- und Spannungswandler im Rahmen der Erfindung eingesetzt werden.

Vorteilhafterweise sind die Messsensoren jedoch Kleinsignalwandler, die insbesondere als Rogowskispulen ausgeführt sind. Kleinsignalwandler weisen den Vorteil auf, dass sie kostengüngist am Markt erhältich sind. Gemäß dieser Weiterentwicklung des erfindungsgemäßen Verfahrens und der erfindungsgemäßen Vorrichtung können daher ökonomische Randbedingungen leichter erfüllt werden. Im Rahmen der Erfindung müssen nicht alle Messsensoren als Kleinsignalwandler ausgeführt sein. Es ist im Rahmen der Erfindung auch möglich, dass ein Teil der Messsensoren als Strom- oder Spannungswandler und die übrigen Messsensoren als Kleinsignalwandler ausgebildet sind.

Vorteilhafterweise verfügt jedes IED über ein GPS Modul und eine interne Uhr, wobei die Uhren der IEDs über das GPS-Modul miteinander synchronisiert werden und wobei jede IED jedem Messwert einen Zeitstempel zuordnet und den Messwerten der jeweiligen IED eine Ortsinformation hinzufügt. Gemäß dieser erfindungsgemäßen Weiterentwicklung von Verfahren und Vorrichtung verfügen die IEDs jeweils über eine Uhr. Um die Uhren mit einer externen Uhr (GNSS) zu synchronisieren ist das GPS-Modul vorgesehen. Mittels des GPS-Moduls ist eine Masterclock oder Masteruhr bereitgestellt, mit der sich alle Uhren der erfindungsgemäßen Vorrichtung synchronisieren.

Der Abstand zwischen den Messstellen ist grundsätzlich beliebei. Die Leiterabschnitte erstrecken sich bevorzugt vom Anfang bis zum Ende der Leitung. Auf diese Weise die gesamte Länge der Leitung überwacht werden kann. Bevorzugt ist an jedem oder jedem zweiten oder jedem vierten Strommast eine Messstelle vorgesehen.

Im Rahmen der Erfindung ist vorteilhafterweise jedem Messsensor ein IED zugeordnet. Sind beispielsweise 20 Messstellen mit 20 Messensoren vorgesehen, sind im Rahmen dieser vorteilhaften Weiterentwicklung 20 IEDs vorgesehen. Abweichend davon sind mehrere Messsensoren mir einer IED verbunden. Hierbei ist sichergestellt, dass die IED mehrere Eingänge aufweist und die getrennte Verarbeitung der empfangenen Messsignale ermöglicht ist.

Die Messsensoren sind über eine Kommunikationsverbindung die drahtgeführt oder drahtlos ausgeführt sein kann, mit dem jeweiligen IED verbunden. Ist ein IED mit mehreren IEDs verbunden, muss für die möglicherweise vorliegende Synchronisation der Messwerte eine unterschiedlich lange Übertragungszeit der Messsignale an die IED berücksichtigt werden.

Vorteilhafterweise senden die IEDs die Messwerte über einen Multiplexer an die Leitstellenanordnung. Dem Fachmann ist die Funktionsweise eines Multiplexers bekannt, so dass weitere Ausführungen hierzu an dieser Stelle entfallen können.

Gemäß einer diesbezüglich zweckmäßigen Weiterentwicklung ordnet der Multiplexer die Messwerte einer IED jeweils einem Datenkanal zu, ordnet die Datenkanäle hintereinander an und versieht die hintereinander angeorndeten Datenkanäle mit einem Rahmen, wobei der Rahmen anschließend der Leitstellenanordnung zugesendet wird. Auf diese Art und Weise wird die Auswertung der Messwerte an der Leitstellenanordnung vereinfacht.

Leitstellenanordnungen sind einzelne oder Gruppen von zentral oder dezentral angeordneten Datenverarbeitungseinrichtungen, die meist komplexen Algorithmen zur Beobachtung und/oder zur Steuerung der Anlage ausführen. Leitstellenanordnungen besitzen üblicherweise eine Mensch-Maschine-Schnittstelle, die es einem Betreiber der Anlage ermöglicht, den Zustand der Anlage insgesamt sowie denjenigen der einzelnen Komponenten der Anlage zu beobachten, zu überwachen und steuernd auf einzelne oder mehrere Komponenten einzuwirken.

Intelligente elektronische Geräte (z.B. sogenannte IEDs - intelligent electronic devices) sind Geräte, die unter Ausführung bestimmter Algorithmen selbständig Aufgaben zur Automatisierung der Anlage wahrnehmen (z.B. sogenannte Fehlerindikatoren, die einen in einer Leitung fließenden Strom messen und bei Überschreitung eines Schwellenwertes ein Alarmsignal abgeben). IEDs können in diesem Zusammenhang insbesondere Schutz- und Steuergeräte, Messgeräte, Power Quality Geräte oder Leistungsmessgeräte (Power Meter) sein.

Gemäß einer bevorzugten Variante der Erfindung werden die Messwerte als vektorielle Zeigergrößen ermittelt, die einen Betrag und eine Richtung aufweisen.

Vorteilhafterweise wird die Differenz zwischen jedem Messwert (M) und einem Sollwert (S) als Abweichungswert (A = S - M) ermittelt und der Abweichungswert mit einem zuvor festgelegten Schwellenwert verglichen, wobei bei Überschreiten des Schwellenwertes ein Fehlersignal erzeugt wird. Dieses Verfahren, das als Algorithmus in der Leitstellenanordnung abgelegt ist, wird von der Leitstellenanordnung durchgeführt.

Gemäß einer diesbezüglichen Weiterentwicklung, wird bei Überschreiten des Schwellenwertes jeder Messwert einer Messstelle in einem Leterabschnitt A unter Gewinnung eines Abschnittsvergleichswerts mit dem zeitgleich erfassten Messwert einer Messstelle verglichen, die einem Leiterabschnitt B zugeordnet ist, wobei die Leiterabschnitte A und B und somit die Messstellen aufeinander folgend also direkt hintereinander angeordnet sind und wobei der Abschnittsvergleichswert mit einem zuvor festgelegten Toleranzschwellenwert verglichen wird. Dieser Toleranzschwellenwert kann abweichend davon dynamisch in Abhängigkeit der aktuellen Messwerte festgelgt werden. Übersteigt der Abschnittsvergleichswert den Toleranzschwellenwert, kann über die den Messwerten beigefügte Ortsinfomation der Fehlerort eingegrenzt werden.

Vorteilhafterweise sind die IEDs über eine beliebige Kommunikationsverbindung mit einem Multiplexer verbunden sind, der zur Kommuniktion mit der Leitstellenanordnung eingerichtet ist.

Bevorzugt ist der Leiter ein luftisolierter Freileiter, der an einem Strommast isoliert montiert ist, wobei sich der Strommast am Erdboden abstützt. Luftisolierte Freileiter sind im Vergleich zu Kableleitern kostengünstig und übertragen die elektrische Energie mit weniger Verlusten, da Kabelleiter eine vom Wechselstrom polarisierbare Kunststoffisolierung aufweisen.

Gemäß einer diesbezüglich zweckmäßigen Weiterentwickliung ist der Leiter an einer, mehreren oder allen Messtellen jeweils über einen Messleiter mit einem Messwandler verbunden. Abweichend davon ist an einer, mehreren oder allen Messstellen eine Rogowskispule angeordnet, die über einen Kommunikationsleiter mit dem IED verbunden ist. Im Rahmen der Erfindung können Messwandler und Kleinsignalwandler gemischt auftreten. Abweichend davon sind alle Messsensoren Kleinsignalwandler oder Messwandler.

Weitere zweckmäßige Ausgestaltungen und Vorteile der Erfindung sind Gegenstand der nachfolgenden Beschreibung von Ausführungsbeispielen der Erfindung unter Bezug auf die Figuren der Zeichnung, wobei die
- Figur 1: eine Vorrichtung gemäß dem Stand der Technik
- Figur 2: ein Ausführungsbeispiel der erfindungsgemäßen Vorrichtung
- Figur 3: ein weiteres Ausführungsbeispiel der erfindungsgemäßen Vorrichtung
- Figur 4: die Wirkungsweise eines Muliplexers und
- Figur 5: ein Ausführungsbeispiel des Auswertealgorithmus der Leitstellenanordnung schematisch verdeutlichen.

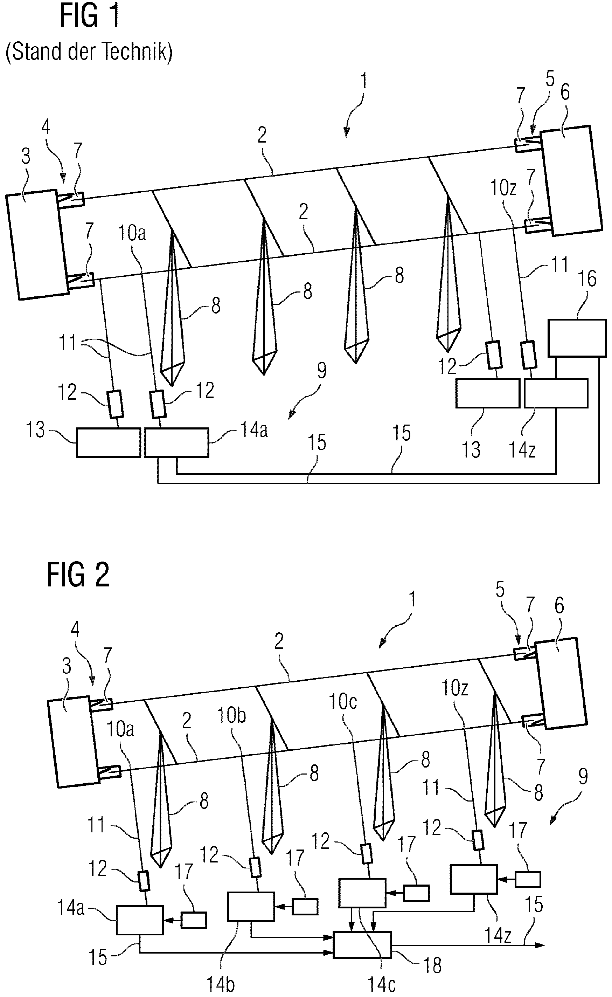

Figur 1 verdeutlicht eine bekannte Vorrichtung 1 gemäß dem Stand der Technik. Die besagte Vorrichtung 1 weist einen Leiter 2 auf, der Teil eines elektrischen Energieversorgungsnetzes ist. Der Leiter 2 weist weder Knoten noch Maschen noch Abzweigungen auf und dient zur elektrischen Übertragung von Energie, die von einem Generator 3, der beispielsweise in Hamburg angeordnet ist, in den Leiter 2 eingespeist wird. Der Leiter überträgt die Energie zu einem in Berlin ansässigen Verbraucher 6. Dabei erstreckt sich der Leiter von seinem Anfang 4 bis zu seinem Ende 5, wobei am Anfang 4 der Generator 3 und am Ende 5 der Verbraucher 6 angeordnet sind. Zwischen dem Anfang 4 und dem Ende 5 des Leiters 2 liegen mehrere hundert Kilometer. Der Leiter liegt auf einem Hochspannungspotential.

In der Figur sind zwei parallel geführte Leiter 2, ein unterer und ein oberer Leiter 2, gezeigt. Die Leiter 2 sind identisch ausgeführt. Im Folgenden werden sich die Ausführungen jedoch nur auf den unteren Leiter 2 beziehen, sie gelten jedoch für den oberen Leiter 2 entsprechend.

Am Anfang 4 und am Ende 5 des Leiters sind Leistungsschalter 7 erkennbar, die in der Lage sind, den Leiter 2 vom restlichen Teil des Energieversorgungsnetzes abzutrennen. Der Leiter 2 ist luftisoliert und wird von Strommasten 8 isoliert gehalten. Die Strommasten stützen sich am Erdboden 9 ab.

An einer Messstelle 10a, die am Anfang 4 des Leiters 2 angeordnet ist, sowie an einer Messstelle 10z, die am Ende 5 des Leiters 2 angeordnet ist, ist der Leiter 2 über zwei Verbindungsleiter 11 mit Messsensoren 12 verbunden, wobei einer der Messsensoren 12 mit einem Wanderwellenrekorder 13 und der andere Messsensor mit einem Schutzgerät 14 verbunden ist. Entsprechendes gilt für die Messwandler 12 am Ende 5 des Leiters 2.

Die Schutzgeräte 14 sind über eine Kommunikationsverbindung 15 miteinander und über weitere Kommunikationsverbindungen 15 mit einer Leitstellenanordnung 16 verbunden. Die Kommunikationsverbindungen 15 können kabelgeführte Kommunikationsverbindungen aber auch kabellose Kommunikationsverbindungen sein. Kabellose Kommunikationsverbindungen sind beispielsweise Funkverbindungen. Hierbei kommen alle gängigen Funkverbindungen in Betracht. Auch die kabelgeführten Kommunikationsverbindungen können grundsätzlich beliebig ausgeführt sein.

Die in Figur 1 gezeigten Messsensoren 12 sind als Stromwandler ausgeführt. Sie erfassen den an der jeweils zugeordneten Messstelle 10a bzw. 10z fließenden Strom und stellen ausgangsseitig ein hochspannungsfreies geeichtes Messsignal bereit, das dem jeweiligen Schutzgerät 14a bzw. 14b über eine Verbindungsleitung 11 zugeführt wird. Die Schutzgeräte 14a und 14b tasten die analogen Strommesssignale jeweils unter Gewinnung von Stromabtastwerten ab, wobei die Stromabtastwerte anschließend digitalisiert und mit einem Zeitstempel versehen werden. Die Messwerte mit ihren Zeitstempeln werden anschließend in Gestalt von Datentelegrammen der Leitstellenanordnung 16 über die Kommunikationsleitungen 15 zugeführt.

Fig. 2 zeigt ein Ausführungsbeispiel der erfindungsgemäßen Vorrichtung 1, die sich wieder von einem Generator 3, der in Hamburg aufgestellt ist, zu einem Verbraucher 6 in Berlin erstreckt. Hierbei sind gleich wirkende Bauteil mit gleichen Bezugszeichen versehen. Die obenstehenden Ausführungen zu diesen Bauteilen gelten hier entsprechend.

Der Leiter 2 erstreckt sich von einem Anfang 4 zu einem Ende 5, wobei am Anfang 4 des Leiters 2 eine Messstelle 10a angeordnet ist. Am Ende 5 des Leiters 2 befindet ist die Messstelle 10z erkennbar. Wie in Fig. 1 ist auch in Fig. 2 ein weiterer Leiter gezeigt, der oberhalb des Leiters 2 angeordnet ist. Im Folgenden wird jedoch nur auf den unteren Leiter 2 eingegangen, wobei die Ausführung zu dem unteren Leiter 2 für den oberen Leiter 2 entsprechend gelten sollen.

Wieder sind am Anfang 4 und am Ende 5 Leiter 2 Leistungsschalter 7 vorgesehen, die bei Erhalt eines Fehlersignals den Leiter 2 vom restlichen Teil des elektrischen Energieversorgungsnetzes abtrennen. Der Leiter 2 ist als luftisolierter Freileiter ausgeführt und wird von Strommasten 8 isoliert gehalten, wobei die Masten sich an dem Erdboden 9 abstützen.

Neben den Messstellen 10a und 10z am Anfang 4 beziehungsweise am Ende 5 des Leiters 2 sind gemäß der vorliegenden Erfindung weitere Messstellen 10b und 10c vorgesehen, an denen der Leiter 2 über Verbindungsleiter 11 mit weiteren Messsensoren 12 verbunden ist. Alle Messwandler 12 sind in Fig. 2 als Stromwandler ausgeführt. Jeder Stromwandler 12 ist ausgangsseitig mit dem Eingang einer IED 14a, 14b, 14c und 14z verbunden, wobei die IEDs 14 in dem in Fig. 2 gezeigten Ausführungsbeispiel Schutzgeräte sind. Abweichend davon können die IEDs 14 jedoch auch als so genannte Merging Units oder Vorverarbeitungseinheiten ausgebildet sein.

Jedes IED 14 tastet jeweils die empfangenen analogen Messsignale des jeweiligen Messsensors 12 ab. Ein Analog-Digital-Wandler digitalisiert die dabei gewonnen Abtastwerte unter Erhalt digitaler Messwerte. Darüber hinaus verfügt jede IED über eine interne Uhr und ist mit einem GPS- oder "Global-Positioning-System"-Modul verbunden. Auf diese Weise kann eine externe Synchronisierung erfolgen. Mit Hilfe des GPS-Moduls können die Uhren aller IEDs 14 mit einer externen Uhr synchronisiert werden, so dass Messwerte mit gleichen Zeitstempeln miteinander verglichen werden können. Das GPS-Modul stellt dazu eine so genannte Masterclock oder Masteruhr bereit, nach der sich die Uhren der IEDs, die sich im Slave-Zustand befinden, richten. Mittels des GPS-Moduls können den Messwerten auch die Positionsdaten der jeweiligen Messstellen 10a, 10b, 10c oder 10z zugeordnet werden.

Die ausgangsseitig der Stromwandler 12 bereitgestellten Ausgangssignale entsprechen dem an der jeweiligen Messstelle 10a, 10b, 10c oder 10z erfassten Strom, der von dem Leiter 2 dort geführt wird. Die digitalen Messwerte jeder Messstelle 10a, 10b, 10c oder 10z werden als Zeigergrößen ermittelt und darüber hinaus von der jeweiligen IED jeweils mit einem Zeitstempel und dem genauen Positionsdatum versehen. Diese besagten Daten werden gebündelt in Gestalt von Datentelegrammen an einen Mulitplexer 18 gesendet. Zur Datenübertragung dient wieder eine Kommunikationsverbindung 15, die in dem gezeigten Ausfügungsbeispiel kabellos ausgebildet ist. Der Multiplexer 18 verarbeitet die ihm von den IEDs 14a, 14b, 14c und 14z gesendeten Datentelegramme und überträgt sie gebündelt an eine in der Figur nicht dargestellte Leitstellenanordnung. Die Wirkungsweisen des Mulitplexers 18 und der Leitstellenanordnung 16 wird weiter unten noch genauer erläutert.

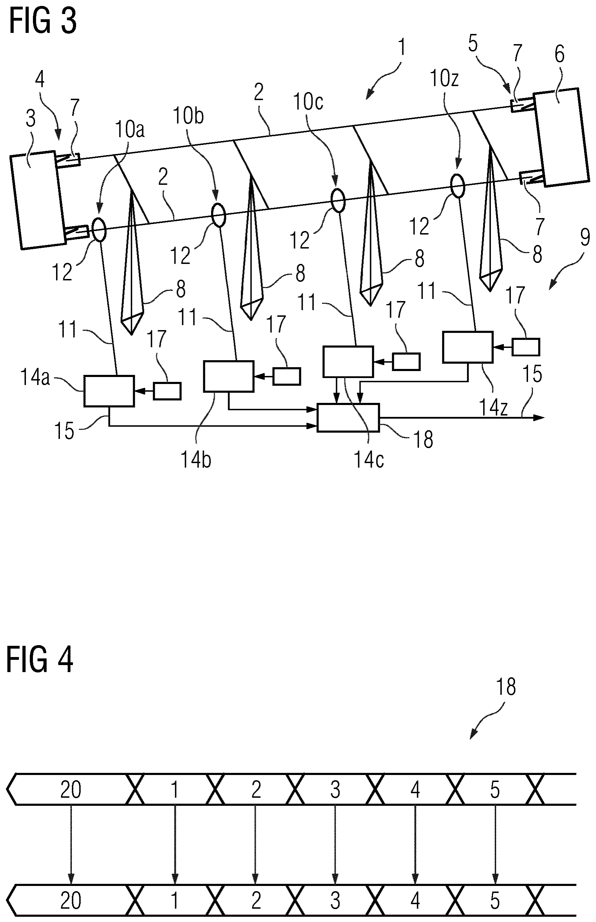

Fig. 3 zeigt ein weiteres Ausführungsbeispiel der erfindungsgemäßen Vorrichtung 1, die sich von dem in Figur 2 gezeigten Ausführungsbeispiel nur durch den Einsatz anderer Messsensoren 12 unterscheidet. In dem in Fig. 3 gezeigten Ausführungsbeispiel werden anstelle von Stromwandlern Kleinsignalwandler in Gestalt von Rogowskispulen eingesetzt. Die Rogowskispulen 12 sind direkt am Leiter angeordnet und über Kommunikationsverbindungsleiter 15 wieder jeweils mit der zugeordneten IEDs 14a, 14b, 14c und 14z verbunden, die wie zuvor erhaltenen Messsignale der Rogowskispulen abasten, digitalisieren und mit Zeit- und Ortsdaten an den Multiplexer 18 senden, der wiederum die Messwerte bündelt und gemeinsam an eine figürlich nicht dargestellte Leitstellenanordnung überträgt.

Fig. 4 verdeutlicht die Wirkungsweise des Multiplexers 18. Der Multiplexer 18 ordnet alle von einer IED 14a, 14b, 14c beziehungsweise 14z erhaltenen Datentelegramme einem Kanal 1, 2, 3, 4 oder 5 zu. Beispielsweise werden die Messwerte der Messstelle 10a dem Datenkanal 1, die Datentelegramme der Messstelle 10b dem Kanal 2, die Datentelegramme der Messstelle 10c dem Kanal 3 zugeordnet. Die Kanäle 1, 2, 3, 4, 5 enthalten somit die mit Ortsdaten versehenen zeitgestempelten Messwerte der jeweiligen Messstelle 10a, ..., 10z. Der Multiplexer 18 ordnet nun die Kanäle in zeitlicher Reihenfolge hintereinander an und versieht diese mit einem Multiplex-Rahmen, der mit einem Rahmenkennwort 20 versehen wird. Der Rahmen wird anschließend an die Leitstellenordnung 16 versandt, die einen De-Multiplexer aufweist, der den jeweils ankommenden Rahmen des Multiplexers 18 auflöst und die in den Kanälen angeordneten Datentelegramme anschließend auswertet. Dies ist in Fig. 4 durch die nach unten zeigenden Pfeile verdeutlicht.

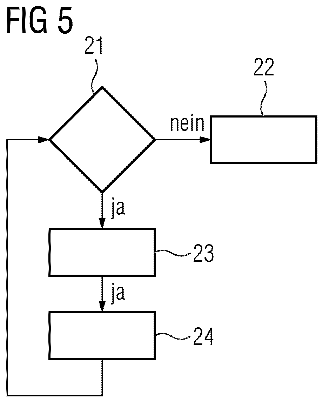

Fig. 5 zeigt schematisch ein Ausführungsbeispiel des erfindungsgemäßen Verfahrens. Zunächst stellt ein auf der Leistellenanorndung 16 hinterlegter Algorithmus in dem Verfahrensschritt 21 fest, ob der Betrag der Abweichung A eines Messwertes M von einem Sollwert S (A=M-S) einen Schwellenwert übersteigt. Ist dies nicht der Fall, erfolgen keine weitere Maßnahmen. Dies ist mit dem Verfahrenskästchen 22 symbolisiert.

Ist die Abweichung A jedoch größer als der Schwellenwert, so wird auf einen Fehler geschlossen. Der Fehler kann nun im Verfahrensschritt 23 wie folgt lokalisiert werden. Nach Feststellung eines Fehlers werden die Messwerte der ersten Messstelle 10a mit den Messwerten der benachbarten Messstelle 10b verglichen. Ist die Differenz dieser Messwerte kleiner als einen zuvor festgelegter Toleranzwert, wird vom Angang 4 zum Ende 5 hin fortschreitend die sich räumlich anschließende nächste Messstelle 10b ausgewählt und mit dem zeitgleichen Messwert der nächsten Messstelle 10c verglichen. Dies wird solange fortgesetzt bis der Unterschied oder mit anderen Worten die Differenz der zeitgleichen Messwerte den Toleranzwert übersteigt. Ist dies der Fall, kann der Felhlerort eingegrenzt werden.

Im Verfahrenschritt 24 erfolgt die entsprechende Fehlermeldung. Anschließend wird das Verfahern erneut durchlaufen.

## Patentansprüche

1. Verfahren zum Ermitteln eines Fehlerortes in einem Leiter (2) eines elektrischen Energieversorgungsnetzes, bei dem an einer Messtelle (10a) am Anfang 4 und an einer Messstelle (10z) am Ende 5 des Leiters (2) Messensoren (12) angeordnet sind, die jeweils eine Messgröße erfassen, die den Zustand des Leiters (2) charakterisiert, wobei die Messsensoren (12) ausgangseitig Messignale bereitstellen und mit einem intelligenten elektronisches Gerät, IED, (14) verbunden sind, das aus den Messsignalen digitale Messwerte erzeugt, **dadurch gekennzeichnet dass,** weitere Messsensoren (12) vorgesehen sind, die jeweils an weiteren Messtellen (10b, 10c) des Leiters (2) angeordnet sind und eine Messgröße an der zugeordneten Messtelle (10a, 10c) erfassen, die den Zustand eines zugeordneten Leiterabschnitts des Leiters (2) charakterisiert, wobei die Leiterabschnitte aufeinander folgend und hintereinander angeordnet sind und wobei die weiteren Messensoren (12) ebenfalls mit einem IED (14) verbunden sind und jedes IED (14) die aus dem jeweiligen Messsignal erzeugten Messwerte an eine Leitstellenanordnung (16) überträgt, die mit Hilfe eines Algorithmus die Messwerte auf das Vorliegen einer Fehlerbedinung hin untersucht und bei Vorliegen einer Fehlerbedingung ein Fehlersingal erzeugt.

2. Verfahren nach Anspruch 1, **dadurch gekennzeichnet, dass** die Messsensoren (12) Kleinsignalwandler und insbesondere als Rogowskispule ausgeführt sind.

3. Verfahren nach einem der vorhergehenden Ansprüche, **dadurch gekennzeichnet, dass** jedes IED (14) über ein GPS Modul (17) und eine interne Uhr verfügt, wobei die Uhren der IEDs über das GPS-Modul (17) mit einer externen Uhr synchronisiert werden, wobei jede IED (14) jedem Messwert einen Zeitstempel zuordnet und den Messwerten eine Ortsdatum hinzufügt.

4. Verfahren nach einem der vorhergehenden Ansprüche, **dadurch gekennzeichnet, dass** die IEDs (14) zumindest teilweise die Messwerte über einen Multiplexer (18) an die Leitstellenanordnung (16) senden.

5. Verfahren nach Anspruch 4, **dadurch gekennzeichnet, dass** der Multiplexer (18) die Messwerte einer IED (14) jeweils einem Datenkanal zuordnet, die Datenkanäle zeitlich hintereinander anordnet und die hintereinander angeordneten Datenkanäle mit einem Rahmen versieht, wobei der Rahmen anschließend der Leitstellenanordnung (16) zugesendet wird.

6. Verfahren nach einem der vorhergehenden Ansprüche, **dadurch gekennzeichnet, dass** die Messwerte als vektorielle Zeigergrößen ermittelt werden, die einen Betrag und eine Richtung aufweisen.

7. Verfahren nach einem der vorhergehenden Ansprüche, **dadurch gekennzeichnet, dass** die Differenz zwischen jedem Messwert (M) und einem Sollwert (S) als Abweichungswert (A = S - M) ermittelt und der Abweichungswert (A) mit einem Schwellenwert verglichen wird, wobei bei Überschreiten des Schwellenwertes ein Fehlersignal erzeugt wird.

8. Verfahren nach Anspruch 7, **dadurch gekennzeichnet, dass** bei Überschreiten des Schwellenwertes jeder Messwert einer Messstelle (10) in einem Leiterabschnitt unter Gewinnung eines Abschnittsvergleichswerts mit dem zeitgleich erfassten Messwert einer Messstelle vergleichen wird, die einem Leiterabschnitt B zugeordnet ist, wobei die Leiterabschnitte A und B und somit die Messstellen aufeinander folgend also direkt hintereinander angeordnet sind und wobei der Abschnittsvergleichswert mit einem zuvor festgelegten Toleranzschwellenwert verglichen wird und wobei bei Überschreiten des Toleanzschwellenwertes die Positionsdaten der an der Toleranzwertüberschreitung beteiligten Messstellen zur Eingrenzung des Fehlerortes herangezogen werden.

9. Vorrichung (1) zur Überwachung eines Leiters (2) eines elektrischen Energieversorgungsnetzes mit an einer Messtelle (10a) am Anfang (4) und an einer Messtelle (10z) am Ende (5) des Leiters (2) angeordneten Messsensoren (12), die jeweils eine Messgröße erfassen, die den Zustand des Leiters (2) charakterisiert, wobei jeder Messsensor (12) ausgangseitig Messignale bereitstellt und mit einem intelligenten elektronisches Gerät, IED, (14) verbunden sind, das aus den Messsignalen digitale Messwerte erzeugt, **dadurch gekennzeichnet dass,** weitere Messsensoren (12) vorgesehen sind, die an weiteren Messtellen (10b, 10c) des Leiters (2) angeordnet sind und eine Messgröße an der zugeordneten Messstelle (10b, 10c) erfassen, die den Zustand eines zugeordneten Leiterabschnitts charakterisiert, wobei die Leiterabschnitte aufeinander folgend und hintereinander angeordnet sind und wobei die weiteren Messensoren (12) ebenfalls mit einem IED (14) verbunden sind und jedes IED (14) dazu eingerichtet ist, die aus dem jeweiligen Messsignal erzeugten Messwerte an eine Leitstellenanordnung (16) zu übertragen.

10. Vorrichtung (1) nach Anspruch 9, **dadurch gekennzeichnet, dass** jedes IED (14) über ein GPS-Modul (17) und eine interne Uhr verfügt, wobei die Uhren der IEDs über das GPS-Modul (17) mit einer externen Uhr synchronisierbar sind, wobei jede IED (14) dazu eingerichtet ist, jedem Messwert einen Zeitstempel zu zuordnen und den Messwerten der jeweiligen IED (14) ein Ortsdatum hinzu zu fügen.

11. Vorrichtung (1) nach einem der Ansprüche 9 oder 10, **dadurch gekennzeichnet, dass** IEDs (14) über eine Kommunikationsverbindung (15) mit einem Multiplexer (18) verbunden sind, der zur Kommuniktion mit der Leitstellenanordnung (16) eingerichtet ist.

12. Vorrichtung (1) nach einem der Ansprüche 9 bis 11, **dadurch gekennzeichnet, dass** der Leiter ein luftisolierter Freileiter (2) ist, der an einem Strommast ( 8) isoliert montiert ist, wobei sich der Strommast (8) am Erdboden (9) abstützt.

13. Vorrichtung (1) nach Anspruch 12, **dadurch gekennzeichnet, dass** der Leiter (2) an der jeweiligen Messtelle (10a,..., 10z) über einen Messleiter (11) mit einem an einer IED (14) angeschlossenen Messwandler (12) verbunden ist oder dass an der jeweiligen Messstelle (10a,..., 10z) ein Kleinsignalwandler angeornet ist, der über einen Kommunikatikonsleiter mit einer IED (14) verbunden ist.

14. Vorrichtung (1) nach Anspruch 12 oder 13, **dadurch gekennzeichnet, dass** an jedem, an jedem zweiten oder jedem vierten Strommast (8) eine Messstelle (10a,..., 10z) vorgesehen ist.
